# EUROPEAN PATENT SPECIFICATION

(11) **EP 4 125 121 B1**
(45) Date of publication and mention of the grant of the patent: **28.08.2024**
(21) Application number: 22187296.3
(22) Date of filing: 27.07.2022
(51) Int. Cl.: H01L 23/495, H01L 23/498

(54) **METHOD OF MANUFACTURING SUBSTRATES FOR SEMICONDUCTOR DEVICES, CORRESPONDING SUBSTRATE AND SEMICONDUCTOR DEVICE**
VERFAHREN ZUR HERSTELLUNG VON SUBSTRATEN FÜR HALBLEITERBAUELEMENTE, ENTSPRECHENDES SUBSTRAT UND HALBLEITERBAUELEMENT
PROCÉDÉ DE FABRICATION DE SUBSTRATS POUR DISPOSITIFS À SEMICONDUCTEUR, SUBSTRAT CORRESPONDANT ET DISPOSITIF À SEMICONDUCTEUR

(30) Priority: 28.07.2021 IT 202100020114
(43) Date of publication of application: 01.02.2023
(73) Proprietor: STMicroelectronics S.r.l., 20864 Agrate Brianza (MB) (IT)
(72) Inventor: MAZZOLA, Mauro, 24040 Calvenzano (Bergamo) (IT)
(74) Representative: Bosotti, Luciano

(56) References cited:
- US-A1- 2020 135 632
- US-B1- 7 732 914

## Description

### Technical field

The description relates to semiconductor devices.

One or more embodiments can be applied to semiconductor power devices for the automotive sector, for instance.

### Background

In substrates such as pre-molded leadframes, adequate adhesion between the sculptured, electrically conductive structure of the leadframe (copper, for instance) and the pre-mold resin (an epoxy resin, for instance) molded thereon should desirably absorb stresses generated if the pre-molded leadframe is pressed or bent.

Particularly, pads in pre-molded leadframes should desirably resist pressing forces (as developed, e.g., during ribbon ultrasonic wedge bonding) as well as pulling forces (as developed, e.g., during ribbon pulling for second bond, or as a result thermo-mechanical stress under operation).

It is noted that, while advantageous for other purposes, slot-like anchoring structures provide limited pulling resistance while taking a non-negligible pad area.

More specifically, the invention relates to method according to the preamble of claim 1, which is known, for instance, from US 7 732 914 B1. Document US 2020/135632 A1 is also of some interest for the invention.

### Object and summary

An object of one or more embodiments is to deal with the issues as discussed in the foregoing.

According to one or more embodiments, that object can be achieved thanks to a method having the features set forth in claim 1 that follows.

One or more embodiments relate to a corresponding substrate (leadframe) for semiconductor devices as per claim 7.

One or more embodiments relate to a semiconductor device as per claim 12.

The claims are an integral part of the technical teaching provided herein with reference to the embodiments.

One or more embodiments provide a die pad design for a pre-molded leadframe (formed through standard half-etch before pre-molding, by a leadframe supplier, for instance) comprising an alternation of 'fingernail-like' anchoring structures on the top and bottom sides of the die pad.

### Brief description of the annexed figures

One or more embodiments will now be described, by way of example only, with reference to the annexed figures, wherein:
Figure 1 is exemplary of a conventional substrate such as a pre-molded leadframe and of forces that may be applied to such a leadframe;
Figure 2 is exemplary of a similar substrate provided with slot-like anchoring structures;
Figures 3A and 3B are cross-sectional along line II-II of Figure 2 showing how a substrate as illustrated in Figure 2 can resist opposite forces applied thereto;
Figure 4 is a perspective view of a part of the structure of a substrate such as a pre-molded leadframe according to embodiments of the present description;
Figure 5 is a cross-sectional view along lines V-V in Figure 4; and
Figure 6 and 7 are view substantially corresponding to the view of Figure 5 showing possible variants of embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description, various specific details are illustrated in order to provide an in-depth understanding of various examples of embodiments according to the description. The embodiments may be obtained without one or more of the specific details, or with other methods, components, materials, etc. In other cases, known structures, materials, or operations are not illustrated or described in detail so that various aspects of the embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment", "in one embodiment", or the like, that may be present in various points of the present description do not necessarily refer exactly to one and the same embodiment. Furthermore, particular configurations, structures, or characteristics may be combined in any adequate way in one or more embodiments.

The headings/references used herein are provided merely for convenience and hence do not define the extent of protection or the scope of the embodiments.

Semiconductor devices may comprise one or more semiconductor chips or dice arranged (attached) on substrates such as leadframes.

Plastic packages are commonly used for semiconductor devices. Such packages may include a leadframe providing a base substrate comprising electrically conductive material such as copper, sized and shaped to accommodate semiconductor chips or dice and providing pad connections (leads) for these chips or dice.

The designation "leadframe" (or "lead frame") is currently used (see, for instance the USPC Consolidated Glossary of the United States Patent and Trademark Office) to indicate a metal frame that provides support for an integrated circuit chip or die as well as electrical leads to interconnect the integrated circuit in the die or chip to other electrical components or contacts.

Leadframes are conventionally created using technologies such as a photo-etching technology. With this technology, metal (e.g., copper) material in the form of a foil or tape is etched on the top and bottom sides to create various pads and leads.

Substrates such as leadframes are advantageously provided in a pre-molded version wherein an insulating resin (an epoxy resin, for instance) fills the empty spaces between the die pads and leads.

A pre-molded leadframe is a thus a laminar substrate that is substantially flat with the pre-mold material (resin) filling the spaces in the electrically conductive structure (metal material such as copper, for instance) of the leadframe, that has been bestowed a sculptured appearance including empty spaces during forming, by etching, for instance.

The total thickness of the pre-mold leadframe is the same thickness of the sculptured electrically conductive structure.

During the assembly process of semiconductor devices using a pre-molded leadframe, a pre-molded leadframe can be exposed to repeated stress.

Particularly, pads in pre-molded leadframes are exposed to pressing forces (as developed, e.g., during ribbon ultrasonic wedge bonding) as well as to pulling forces (as developed, e.g., during ribbon pulling for second bond, or as a result of thermo-mechanical stress under operation).

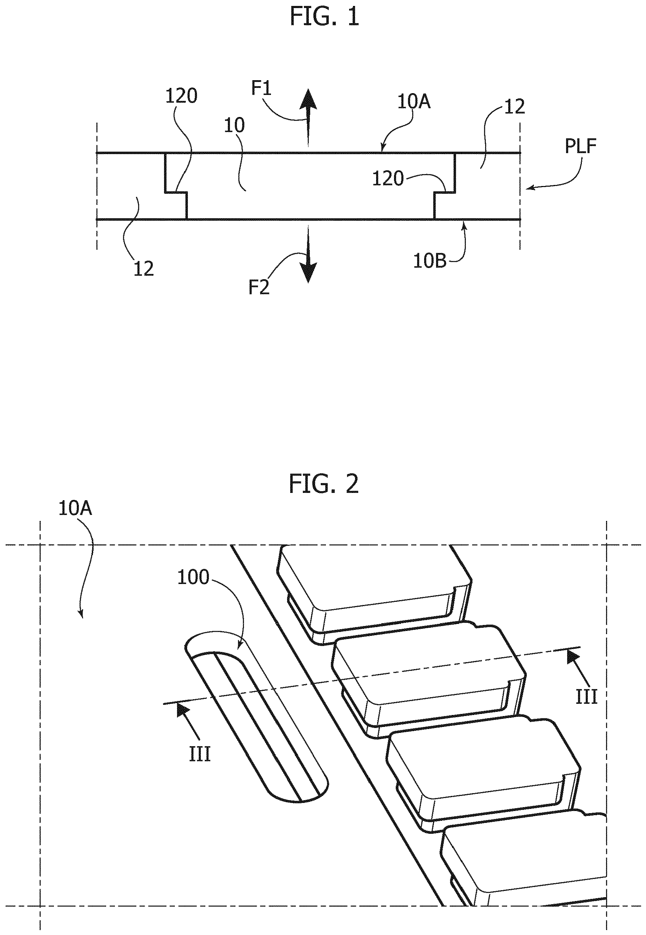

Figure 1 is a cross-sectional view of a portion of a conventional pre-molded leadframe illustrated as comprising, in general, electrically conductive (metal, e.g., copper) portions 10 included in a sculptured, electrically conductive structure of the leadframe (not visible in its entirety), having spaces filled by the pre-mold material (resin) 12.

A pre-molded leaframe PLF as illustrated in Figure 1 has opposite first and second die pad surfaces 10A and 10B, with the first surfaces 10A configured to have at least one semiconductor chip mounted thereon.

Figure 1 is thus exemplary of a conventional approach wherein a sculptured, electrically conductive laminar structure is provided having spaces therein, the laminar structure including one or more die pads 10 having a first die pad surface 10A configured to have at least one semiconductor chip mounted thereon as well as a second die pad surface 10B opposite the first die pad surface 10A.

Figure 1 is likewise exemplary of a conventional approach wherein pre-mold material 12 is molded onto the laminar structure 10. The pre-mold material 12 penetrates into the spaces formed (e.g., etched) in the sculptured, electrically conductive laminar structure and provides a laminar pre-molded substrate PLF, 10, 12 including one or more die pads left exposed by the pre-mold material 12 at the first surface 10A with the periphery of the die pad or pads 10 bordering on the pre-mold material 12 molded onto the laminar structure.

As illustrated in Figure 1, the sculpturing bestowed on the electrically conductive (metal, e.g., copper) portions 10 of the (pre-molded) leadframe is beneficial in keeping all the leadframe parts (leads and die pads) together in a robust structure to facilitate the subsequent process steps.

These steps may include, for instance - after attaching one or more chips or dice on the die pad or pads in the leadframe 10, 12 and the chips or dice being electrically bonded to the leads in the leadframe (not explicitly visible in Figure 1) - a molding resin being molded to provide an insulating encapsulation of a final device.

Figure 1 is exemplary of a leadframe for, e.g., a Quad-Flat No-leads (QFN) device where the sculptured, electrically conductive structure of the leadframe is half etched, that is, a part of copper material is removed, e.g., at the periphery of die pad so that (as visible in Figure 1) the die pad is larger at the front or top surface 10A of the leadframe than at the back or bottom surface 10B of the leadframe.

Half etching can be performed in any manner known to those of skill in the art.

Also, while "half" etching is currently referred to for simplicity, the part of copper material removed does not necessarily correspond to half the thickness of the metal structure of the leadframe.

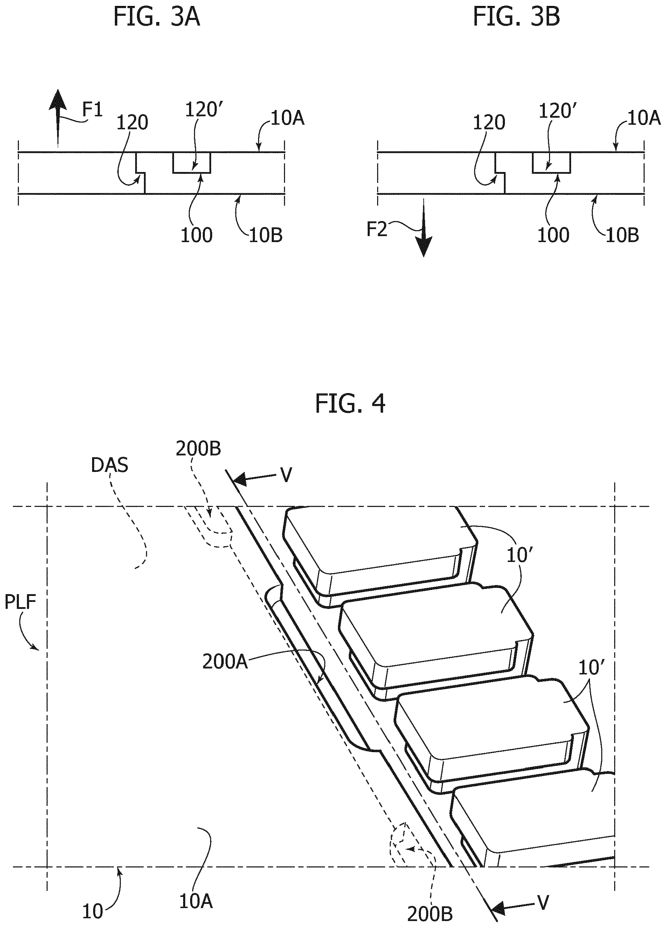

It is noted that the description above also applies *- mutatis mutandis* - to the embodiments discussed in the following, e.g., in connection with Figures 4 to 7. Such a detailed description will not be repeated for brevity.

The die pad being larger at the front or top surface 10A than at the back or bottom surface 10B as illustrated in Figure 1 increases the molding adhesion around the leadframe parts. This is due to a step-like interface formed between the conductive (metal, e.g., copper) portions 10 of the leadframe and the pre-mold material (resin) 12 molded thereon.

After the pre-mold material is solidified (e.g., by thermosetting, as otherwise conventional in the art) this design results in increased resistance to detachment (delamination) between the conductive portions 10 of the leadframe and the non-conductive pre-mold material 12 molded thereon as possibly induced by "pulling" forces F1 (namely forces urging the metal part 10 shown in Figure 1 in the direction from the back or bottom surface 10B towards the front or top surface 10A) and by "pushing" or "pressing" forces F2 (namely forces urging the metal part 10 shown in Figure 1 in the direction from the front or top surface 10A towards the back or bottom surface 10B).

Such a step-like interface includes undercuts as indicated at 120 where the periphery of the conductive portion 10 of the leadframe abuts against the pre-mold material (resin) 12. This provides a form coupling such that the resistance to "pushing" forces F2 (directed downwards in Figure 1) is inevitably (much) higher than the resistance to "pulling" forces F1 (directed upwards in Figure 1).

Forces applied to a pre-molded leadframe such as 10, 12 in Figure 1 during the assembly flow of a semiconductor device include both pressing forces such as, e.g., pressing forces applied during ribbon bonding by a bonding tool together with ultrasonic vibrations and pulling forces, e.g., when a ribbon is pulled or cut by moving or opening a bonding cutting tool.

An arrangement as illustrated in Figure 1, with the undercuts 120 contrasting mainly the pressing forces (e.g., F2) and exhibiting poor adhesion resistance to pulling forces (e.g., F1) cannot be regarded as satisfactory for a variety of practical applications.

Figure 2 and Figures 3A and 3B illustrate a solution as disclosed in US 2021/193591 A1 (to which EP 3 840 040 A1 corresponds) assigned to the same Assignee of the present application.

The leadframe of US 2021/193591 A1 comprises a die pad portion having a first planar die-mounting surface 10A and a second planar surface 10B opposed the first surface 10A.

As visible in Figure 2 (where the conductive structure 10 of the leadframe is shown prior to molding the pre-mold material 12) the die pad surfaces 10A and 10B have facing peripheral rims jointly defining a peripheral outline of the die pad. At least one cavity 100 is provided extending through the die pad from the first planar surface 10A to the second planar surface 10B to define an anchoring portion of the die pad positioned between said at least one cavity and the peripheral outline.

A first etched part extends into the first planar die-mounting surface 10A to a first depth less than a thickness of the die pad and a second etched part extends into the second planar surface to a second depth less than the thickness of the die pad. The first etched part defines a step surface within the cavity 100 that extends parallel to the first planar die-mounting surface 10A and the second etched part defines a thickness of the anchoring portion which is less than the thickness of the die pad.

Figures 3A and 3B (where the pre-mold material 12 is visible, filling the spaces in the sculptured, electrically conductive structure 10 of the leadframe) show that such an arrangement may lead to the formations of undercuts 120, 120' facing in opposite directions.

These undercuts 120 and 120' provide a form coupling of the electrically conductive structure 10 of the leadframe and the pre-mold material 12 providing improved resistance also to pulling forces F1 (Figure 3A) in addition is pushing or pressing forces F2 (Figure 3B) .

Here again, however, the resistance to pushing forces F2 may end up by being higher than the resistance to pulling forces F1, while for certain applications having a resistance to pulling forces F1 equal or possibly higher than the resistance to pushing or pressing forces F2 may be a desirable feature.

In any case, cavities/apertures such as 100 in Figures 2, 3A and 3B subtract area that should be desirably left available for die attachment.

In Figures 4 to 7, parts or elements like parts or elements already discussed in connection with the previous figures are indicated with like reference symbols, so that a detailed description will not be repeated for brevity.

Examples as presented in Figures 4 to 7 comprise, in the place of a half-etched step-like metal-to-resin interface (as illustrated in Figure 1) or slots (such as 100 in Figure 2), an alternation or series of (e.g., fingernail-like) cutaway portions 200A, 200B formed along the border (that is, along the peripheral edge) of the die pad 10, advantageously all around the die pad 10.

These cutaway portions 200A, 200B, that are arranged alternatively (possibly alternately) at the front or top surface 10A and at the back or bottom surface 10B, are filled by the pre-mold resin 12 creating (once the resin is solidified, e.g., via thermosetting) a robust structure of the pre-molded leadframe PLF.

The cutaway portions 200A, 200B may be all equal in shape (e.g., with a same length in the direction of the edges the die pad 10).

The cutaway portions 200A, 200B may be provided equal in number at the front or top surface 10A and at the back or bottom surface 10B, so the resistance and the resin adhesion is balanced in both directions (forces F1 and F2).

The provision of the cutaway portions 200A, 200B does not entail any appreciate reduction of the surface (indicated as DAS in Figure 4) available for die attachment (and possibly for the provision of associated ribbons or wires) at the front surface 10A of the leadframe.

As visible, e.g., in Figure 4 the top or front surface of the die pad designated DAS is exempt from any aperture such as the slot 100 in Figure 2.

It is noted that in the perspective view of Figure 4 the conductive structure 10 of the leadframe is shown prior to molding the pre-mold material 12, with also some of the leads of the leadframe, indicated 10', visible on the right-hand side of Figure 4.

Examples as presented in Figures 4 to 7 comprise at and along the peripheral edge of the pad 10 an alternation of first anchoring formations 200A and second anchoring formations 200B that anchor the pad 10 to the pre-mold material 12 thus providing (once the material 12 is solidified, e.g., via thermosetting) a robust structure of the pre-molded leadframe PLF.

The first anchoring formations 200A are configured to counter "pulling" detachment forces, namely forces such as F1 inducing displacement of the die pad 10 with respect to the pre-mold material 12 in a first direction (upwards in the figures) from the second die pad surface 10B to the first die pad surface 10A.

The second anchoring formations 200B are configured to counter "pushing" or "pressing" detachment forces, namely forces such as F2 inducing displacement of the die pad 10 with respect to the pre-mold material 12 in a second direction (downwards in the figures) from the first die pad surface 10A to the second die pad surface 10A.

As illustrated herein, the first anchoring formations 200A are provided at the first die pad surface 10A and the second anchoring formations 200B are provided at the second die pad surface 10B.

While other shapes (e.g., protrusions) are possible, providing the anchoring formations 200A and 200B as cutaway portions of the peripheral edge of the die pad 10 is advantageous in so far as the pre-mold material 12 can penetrate into these cutaway portions at the peripheral edge of the die pad 10 and establish (once solidified) a strong bond keeping together the various portions of the leadframe PLF.

Irrespective of the specific implementation details, a good degree of flexibility exists in providing an alternation of anchoring formations 200A and 200B along the peripheral edge at one or more of the sides of a die pad such as the die pad 10 illustrated herein.

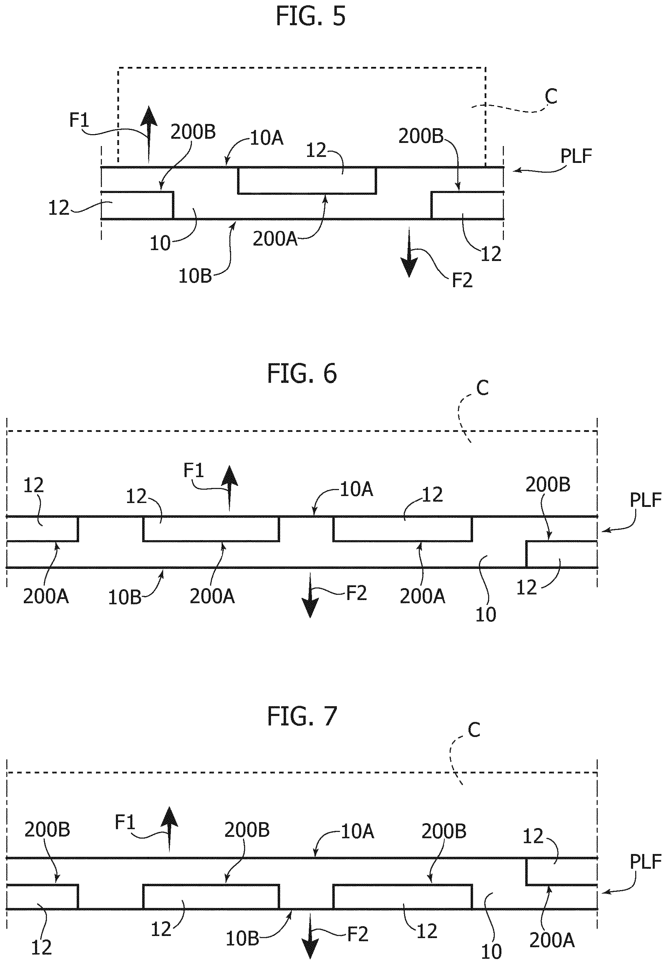

As exemplified in Figure 5 the alternation of first anchoring formations 200A and second anchoring formations 200B may comprise single first anchoring formations 200A alternating (interleaved) with single second anchoring formations 200B.

That is, the alternation as exemplified in Figure 5 comprises the sequence of a first formation 200A, a second formation 200B, a first formation 200A, a second formation 200B, and so on.

As exemplified in Figures 6 and 7 the alternation of first anchoring formations 200A and second anchoring formations 200B may comprises at least one single first anchoring formation 200A alternating with a plurality of second anchoring formations 200B.

For instance:
the alternation as exemplified in Figure 6 comprises the sequence of three first formations 200A followed by a second formation 200B; and
the alternation as exemplified in Figure 7 comprises the sequence of three second formations 200B followed by a first formation 200A.
While not expressly illustrated for brevity, the alternation may comprise plural first formations 200A interleaved with plural second formation 200B.

For instance (this is just one possible example) the alternation may comprise the sequence of three first formations 200A followed by two second formations 200B, in turn followed by three first formations 200A again followed by two second formations 200B, and so on.

Such interleaving may also comprise different numbers of first and second formations at each iteration.

For instance (again, this is just one possible example) the alternation may comprise the sequence of three first formations 200A followed by two second formations 200B, in turn followed by two first formations 200A followed by three second formations 200B, and so on.

This flexibility may be advantageously relied upon to "adjust" as desired the resistance of the leadframe PLF to pulling forces and pushing or pressing forces.

This may possibly take into account the characteristics of the semiconductor chips or dice intended to be mounted (attached) on the leadframe PLF. In Figures 5 to 7 the outline of a semiconductor chip or die C mounted onto the die pad 10 is shown in dashed line.

For instance, providing in the alternation equal numbers of first anchoring formations 200A and second anchoring formations 200B (see, e.g., Figure 5) facilitates making the laminar pre-molded substrate PLF equally resistant to pulling forces F1 and to pushing or pressing forces F2.

Providing in the alternation first anchoring formations 200A higher in number than the second anchoring formations 200B (see Figure 6) facilitate making the laminar pre-molded substrate PLF more resistant to pulling forces F1 than to pushing or pressing forces F2.

Providing in the alternation second anchoring formations 200B higher in number than the first anchoring formations 200A (see Figure 7) facilitate making the laminar pre-molded substrate PLF more resistant to pushing or pressing forces F2 than to pulling forces F1.

Options as exemplified in Figures 6 and 7 may be helpful in dealing with semiconductor chips or dice C mounted on the die pad surface 10A left exposed by the pre-mold material 12 that are warped. This may be the case of large and/or thin semiconductor chips or dice C that may exhibit "crying" or "smiling" shapes.

The extent of protection is determined by the annexed claims.

## Claims

1. A method, comprising:
providing a sculptured electrically conductive laminar structure (10) having spaces therein, the laminar structure including at least one die pad (10) having a first die pad surface (10A) configured to have at least one semiconductor chip (C) mounted thereon as well as a second die pad surface (10B) opposite the first die pad surface (10A), and
molding pre-mold material (12) onto the laminar structure (10), wherein the pre-mold material (12) penetrates into said spaces and provides a laminar pre-molded substrate (PLF, 10, 12) including said first die pad surface (10A) left exposed by the pre-mold material (12) with the peripheral edge of the at least one die pad (10) bordering on the pre-mold material (12) molded onto the laminar structure (10),
**characterized in that** the method comprises providing along the peripheral edge of the at least one die pad (10) an alternation of:
first anchoring formations (200A) of the at least one die pad (10) to the pre-mold material (12), the first anchoring formations (200A) configured to counter first detachment forces (F1) inducing displacement of the at least one die pad (10) with respect to the pre-mold material (12) in a first direction from the second die pad surface (10B) to the first die pad surface (10A); and
second anchoring formations (200B) of the at least one die pad (10) to the pre-mold material (12), the second anchoring formations (200B) configured to counter second detachment forces (F2) inducing displacement of the at least one die pad (10) with respect to the pre-mold material (12) in a second direction from the first die pad surface (10A) to the second die pad surface (10B) .

2. The method of claim 1, comprising providing the first anchoring formations (200A) at the first die pad surface (10A) and the second anchoring formations (200B) at the second die pad surface (10B).

3. The method of claim 1 or claim 2, comprising providing the first (200A) and the second (200B) anchoring formations (200B) as cutaway portions of the peripheral edge of the at least one die pad (10), wherein the pre-mold material (12) molded onto the laminar structure (10) penetrates into said cutaway portions at the peripheral edge of the at least one die pad (10).

4. The method of any of the previous claims, wherein said alternation of first anchoring formations (200A) and second anchoring formations (200B) comprises at least one first anchoring formation (200A) alternating with at least one second anchoring formations (200B).

5. The method of claim 4, wherein said alternation of first anchoring formations (200A) and second anchoring formations (200B) comprises single first anchoring formations (200A) alternating with single second anchoring formations (200B).

6. The method of any of the previous claims, comprising:
providing in said alternation equal numbers of first anchoring formations (200A) and second anchoring formations (200B), wherein the laminar pre-molded substrate (PLF, 10, 12) is equally resistant to said first detachment forces (F1) and to said second detachment forces (F2), or
providing in said alternation first anchoring formations (200A) higher in number than said second anchoring formations (200B), wherein the laminar pre-molded substrate (PLF, 10, 12) is more resistant to said first detachment forces (F1) than to said second detachment forces (F2), or
providing in said alternation second anchoring formations (200B) higher in number than said first anchoring formations (200B), wherein the laminar pre-molded substrate (PLF, 10, 12) is more resistant to said second detachment forces (F2) than to said first detachment forces (F1).

7. A substrate (PLF), comprising:
a sculptured electrically conductive laminar structure (10) having spaces therein, the laminar structure including at least one die pad (10) having a first die pad surface (10A) configured to have at least one semiconductor chip (C1, C2) mounted thereon as well as a second die pad surface (10B) opposite the first die pad surface (10A), and
pre-mold material (12) molded onto the laminar structure (10), wherein the pre-mold material (12) penetrates into said spaces and provides a laminar pre-molded substrate (PLF, 10, 12) including said first die pad surface (10A) left exposed by the pre-mold material (12) with the periphery of the at least one die pad (10) bordering on the pre-mold material (12) molded onto the laminar structure (10),
**characterized in that** along the peripheral edge of the at least one die pad (10) there is provided an alternation of:
first anchoring formations (200A) of the at least one die pad (10) to the pre-mold material (12), the first anchoring formations (200A) configured to counter first detachment forces (F1) inducing displacement of the at least one die pad (10) with respect to the pre-mold material (12) in a first direction from the second die pad surface (10B) to the first die pad surface (10A); and
second anchoring formations (200B) of the at least one die pad (10) to the pre-mold material (12), the second anchoring formations (200B) configured to counter second detachment forces (F2) inducing displacement of the at least one die pad (10) with respect to the pre-mold material (12) in a second direction from the first die pad surface (10A) to the second die pad surface (10B) .

8. The substrate (PLF) of claim 7, wherein the first anchoring formations (200A) and the second anchoring formations are provided at the first die pad surface (10A) and at the second die pad surface (10B), respectively.

9. The substrate (PLF) of claim 7 or claim 8, wherein the first (200A) and the second (200B) anchoring formations (200B) comprise cutaway portions of the peripheral edge of the at least one die pad (10), wherein the pre-mold material (12) molded onto the laminar structure (10) penetrates into said cutaway portions of the peripheral edge of the at least one die pad (10).

10. The substrate (PLF) of any of claims 7 to 9, wherein said alternation of first anchoring formations (200A) and second anchoring formations (200B) comprises at least one single first anchoring formation (200A) alternating with at least one second anchoring formations (200B).

11. The substrate (PLF) of claim 10, wherein said alternation of first anchoring formations (200A) and second anchoring formations (200B) comprises single first anchoring formations (200A) alternating with single second anchoring formations (200B).

12. The substrate (PLF) of any of claims 7 to 11, wherein:
said alternation comprises equal numbers of first anchoring formations (200A) and second anchoring formations (200B), wherein the laminar pre-molded substrate (PLF, 10, 12) is equally resistant to said first detachment forces (F1) and to said second detachment forces (F2), or
said alternation comprises first anchoring formations (200A) higher in number than said second anchoring formations (200B), wherein the laminar pre-molded substrate (PLF, 10, 12) is more resistant to said first detachment forces (F1) than to said second detachment forces (F2), or
said alternation comprises second anchoring formations (200B) higher in number than said first anchoring formations (200A), wherein the laminar pre-molded substrate (PLF, 10, 12) is more resistant to said second detachment forces (F1) than to said first detachment forces.

13. A semiconductor device, comprising:
a substrate (PLF) according to any of claims 7 to 12, and
at least one semiconductor chip (C) mounted on the at least one die pad surface (10A) left exposed by the pre-mold material (12).

## Patentansprüche

1. Verfahren, umfassend:
Bereitstellen einer modellierten elektrisch leitfähigen laminaren Struktur (10), die darin Zwischenräume aufweist, wobei die laminare Struktur mindestens ein Diepad (10) enthält, das eine erste Diepad-Oberfläche (10A) aufweist, die konfiguriert ist, um mindestens einen Halbleiterchip (C) aufzuweisen, der darauf montiert ist, sowie eine zweite Diepad-Oberfläche (10B) gegenüber der ersten Diepad-Oberfläche (10A), und
Anformen eines Vorformlingmaterials (12) an die laminare Struktur (10), wobei das Vorformlingmaterial (12) in die Zwischenräume eindringt und ein laminares vorgeformtes Substrat (PLF, 10, 12) bereitstellt, das die erste Diepad-Oberfläche (10A) enthält, die vom Vorformlingmaterial (12) freiliegend belassen wurde, wobei der periphere Rand des mindestens einen Diepads (10) an das Vorformlingmaterial (12) angrenzt, das an die laminare Struktur (10) geformt ist,
**dadurch gekennzeichnet, dass** das Verfahren entlang des peripheren Randes des mindestens einen Diepads (10) das Bereitstellen umfasst eines Abwechselns von:
ersten Verankerungsformationen (200A) des mindestens einen Diepads (10) zum Vorformlingmaterial (12), wobei die ersten Verankerungsformationen (200A) konfiguriert sind, um ersten Ablösekräften (F1) entgegenzuwirken, die eine Verschiebung des mindestens einen Diepads (10) in Bezug auf das Vorformlingmaterial (12) in einer ersten Richtung von der zweiten Diepad-Oberfläche (10B) zur ersten Diepad-Oberfläche (10A) induzieren; und
zweiten Verankerungsformationen (200B) des mindestens einen Diepads (10) zum Vorformlingmaterial (12), wobei die zweiten Verankerungsformationen (200B) konfiguriert sind, um zweiten Ablösekräften (F2) entgegenzuwirken, die eine Verschiebung des mindestens einen Diepads (10) in Bezug auf das Vorformlingmaterial (12) in einer zweiten Richtung von der ersten Diepad-Oberfläche (10A) zur zweiten Diepad-Oberfläche (10B) induzieren.

2. Verfahren nach Anspruch 1, das Bereitstellen der ersten Verankerungsformationen (200A) an der ersten Diepad-Oberfläche (10A) und der zweiten Verankerungsformationen (200B) an der zweiten Diepad-Oberfläche (10B) umfassend.

3. Verfahren nach Anspruch 1 oder Anspruch 2, das Bereitstellen der ersten (200A) und der zweiten (200B) Verankerungsformationen (200B) als Ausschnittbereiche des peripheren Randes des mindestens einen Diepads (10) umfassend, wobei das Vorformlingmaterial (12), das an die laminare Struktur (10) geformt ist, in die Ausschnittbereiche am peripheren Rand des mindestens einen Diepads (10) eindringt.

4. Verfahren nach einem der vorhergehenden Ansprüche, wobei das Abwechseln der ersten Verankerungsformationen (200A) und der zweiten Verankerungsformationen (200B) mindestens eine erste Verankerungsformation (200A) umfasst, die mit mindestens einer zweiten Verankerungsformation (200B) abwechselt.

5. Verfahren nach Anspruch 4, wobei das Abwechseln der ersten Verankerungsformationen (200A) und der zweiten Verankerungsformationen (200B) einzelne erste Verankerungsformationen (200A) umfasst, die mit einzelnen zweiten Verankerungsformationen (200B) abwechseln.

6. Verfahren nach einem der vorhergehenden Ansprüche, umfassend:
Bereitstellen, in der Abwechslung, von gleichen Anzahlen von ersten Verankerungsformationen (200A) und zweiten Verankerungsformationen (200B), wobei das laminare vorgeformte Substrat (PLF, 10, 12) gegenüber den ersten Ablösekräften (F1) und den zweiten Ablösekräften (F2) gleichermaßen widerstandsfähig ist, oder
Bereitstellen, in der Abwechslung, von ersten Verankerungsformationen (200A) in einer höheren Anzahl als die zweiten Verankerungsformationen (200B), wobei das laminare vorgeformte Substrat (PLF, 10, 12) gegenüber den ersten Ablösekräften (F1) widerstandsfähiger ist als gegenüber den zweiten Ablösekräften (F2), oder
Bereitstellen, in der Abwechslung, von zweiten Verankerungsformationen (200B) in einer höheren Anzahl als die ersten Verankerungsformationen (200B), wobei das laminare vorgeformte Substrat (PLF, 10, 12) gegenüber den zweiten Ablösekräften (F2) widerstandsfähiger ist als gegenüber den ersten Ablösekräften (F1).

7. Substrat (PLF), umfassend:
eine modellierte elektrisch leitfähige laminare Struktur (10), die darin Zwischenräumen aufweist, wobei die laminare Struktur mindestens ein Diepad (10) enthält, das eine erste Diepad-Oberfläche (10A) aufweist, die konfiguriert ist, um mindestens einen Halbleiterchip (C1, C2) aufzuweisen, der darauf montiert ist, sowie eine zweite Diepad-Oberfläche (10B) gegenüber der ersten Diepad-Oberfläche (10A), und
Vorformlingmaterial (12), das an die laminare Struktur (10) angeformt ist, wobei das Vorformlingmaterial (12) in die Zwischenräume eindringt und ein laminares vorgeformtes Substrat (PLF, 10, 12) bereitstellt, das die erste Diepad-Oberfläche (10A) enthält, die vom Vorformlingmaterial (12) freiliegend belassen wurde, wobei die Peripherie des mindestens einen Diepads (10) an das Vorformlingmaterial (12) angrenzt, das an die laminare Struktur (10) geformt ist,
**dadurch gekennzeichnet, dass** entlang des peripheren Randes des mindestens einen Diepads (10) ein Abwechseln bereitgestellt wird von:
ersten Verankerungsformationen (200A) des mindestens einen Diepads (10) zum Vorformlingmaterial (12), wobei die ersten Verankerungsformationen (200A) konfiguriert sind, um ersten Ablösekräften (F1) entgegenzuwirken, die eine Verschiebung des mindestens einen Diepads (10) in Bezug auf das Vorformlingmaterial (12) in einer ersten Richtung von der zweiten Diepad-Oberfläche (10B) zur ersten Diepad-Oberfläche (10A) induzieren; und
zweiten Verankerungsformationen (200B) des mindestens einen Diepads (10) zum Vorformlingmaterial (12), wobei die zweiten Verankerungsformationen (200B) konfiguriert sind, um zweiten Ablösekräften (F2) entgegenzuwirken, die eine Verschiebung des mindestens einen Diepads (10) in Bezug auf das Vorformlingmaterial (12) in einer zweiten Richtung von der ersten Diepad-Oberfläche (10A) zur zweiten Diepad-Oberfläche (10B) induzieren.

8. Substrat (PLF) nach Anspruch 7, wobei die ersten Verankerungsformationen (200A) und die zweiten Verankerungsformationen an der ersten Diepad-Oberfläche (10A) beziehungsweise an der zweiten Diepad-Oberfläche (10B) bereitgestellt sind.

9. Substrat (PLF) nach Anspruch 7 oder Anspruch 8, wobei die ersten (200A) und die zweiten (200B) Verankerungsformationen (200B) Ausschnittbereiche des peripheren Randes des mindestens einen Diepads (10) umfassen, wobei das Vorformlingmaterial (12), das an die laminare Struktur (10) geformt ist, in die Ausschnittbereiche des peripheren Randes des mindestens einen Diepads (10) eindringt.

10. Substrat (PLF) nach einem der Ansprüche 7 bis 9, wobei das Abwechseln der ersten Verankerungsformationen (200A) und der zweiten Verankerungsformationen (200B) mindestens eine einzelne erste Verankerungsformation (200A) umfasst, die mit mindestens einer zweiten Verankerungsformation (200B) abwechselt.

11. Substrat (PLF) nach Anspruch 10, wobei das Abwechseln der ersten Verankerungsformationen (200A) und der zweiten Verankerungsformationen (200B) einzelne erste Verankerungsformationen (200A) umfasst, die mit einzelnen zweiten Verankerungsformationen (200B) abwechseln.

12. Substrat (PLF) nach einem der Ansprüche 7 bis 11, wobei:
das Abwechseln gleiche Anzahlen von ersten Verankerungsformationen (200A) und zweiten Verankerungsformationen (200B) umfasst, wobei das laminare vorgeformte Substrat (PLF, 10, 12) gegenüber den ersten Ablösekräften (F1) und den zweiten Ablösekräften (F2) gleichermaßen widerstandsfähig ist, oder
das Abwechseln erste Verankerungsformationen (200A) umfasst, deren Anzahl höher ist als die zweiten Verankerungsformationen (200B), wobei das laminare vorgeformte Substrat (PLF, 10, 12) gegenüber den ersten Ablösekräften (F1) widerstandsfähiger ist als gegenüber den zweiten Ablösekräften (F2), oder
das Abwechseln zweite Verankerungsformationen (200B) umfasst, deren Anzahl höher ist als die ersten Verankerungsformationen (200A), wobei das laminare vorgeformte Substrat (PLF, 10, 12) gegenüber den zweiten Ablösekräften (F1) widerstandsfähiger ist als gegenüber den ersten Ablösekräften.

13. Halbleitervorrichtung, umfassend:
Substrat (PLF) nach einem der Ansprüche 7 bis 12, und
mindestens einen Halbleiterchip (C), der auf der mindestens einen Diepad-Oberfläche (10A) montiert ist, die vom Vorformlingmaterial (12) freiliegend belassen wurde.

## Revendications

1. Procédé, comprenant :
la production d'une structure laminaire électriquement conductrice sculptée (10) comportant des espaces en son sein, la structure laminaire incluant au moins une plage d'accueil de puce (10) présentant une première surface de plage d'accueil de puce (10A) configurée pour avoir au moins une puce de semi-conducteur (C) montée dessus ainsi qu'une seconde surface de plage d'accueil de puce (10B) opposée à la première surface de plage d'accueil de puce (10A), et
le moulage de matériau de prémoulage (12) sur la structure laminaire (10), le matériau de prémoulage (12) pénétrant dans lesdits espaces et produisant un substrat prémoulé laminaire (PLF, 10, 12) incluant ladite première surface de plage d'accueil de puce (10A) laissée apparente par le matériau de prémoulage (12) avec le bord périphérique de l'au moins une plage d'accueil de puce (10) contigu au matériau de prémoulage (12) moulé sur la structure laminaire (10),
**caractérisé en ce que** le procédé comprend la production, le long du bord périphérique de l'au moins une plage d'accueil de puce (10), d'une alternance :
de premières formations d'ancrage (200A) de l'au moins une plage d'accueil de puce (10) au matériau de prémoulage (12), les premières formations d'ancrage (200A) étant configurées pour s'opposer à des premières forces de séparation (F1) induisant un déplacement de l'au moins une plage d'accueil de puce (10) par rapport au matériau de prémoulage (12) dans un premier sens allant de la seconde surface de plage d'accueil de puce (10B) vers la première surface de plage d'accueil de puce (10A) ; et
de secondes formations d'ancrage (200B) de l'au moins une plage d'accueil de puce (10) au matériau de prémoulage (12), les secondes formations d'ancrage (200B) étant configurées pour s'opposer à des secondes forces de séparation (F2) induisant un déplacement de l'au moins une plage d'accueil de puce (10) par rapport au matériau de prémoulage (12) dans un second sens allant de la première surface de plage d'accueil de puce (10A) vers la seconde surface de plage d'accueil de puce (10B).

2. Procédé selon la revendication 1, comprenant la production des premières formations d'ancrage (200A) au niveau de la première surface de plage d'accueil de puce (10A) et des secondes formations d'ancrage (200B) au niveau de la seconde surface de plage d'accueil de puce (10B).

3. Procédé selon la revendication 1 ou la revendication 2, comprenant la production des premières (200A) et des secondes (200B) formations d'ancrage (200B) sous la forme de portions entaillées du bord périphérique de l'au moins une plage d'accueil de puce (10), le matériau de prémoulage (12) moulé sur la structure laminaire (10) pénétrant dans lesdites portions entaillées au niveau du bord périphérique de l'au moins une plage d'accueil de puce (10).

4. Procédé selon n'importe laquelle des revendications précédentes, dans lequel ladite alternance de premières formations d'ancrage (200A) et de secondes formations d'ancrage (200B) comprend au moins une première formation d'ancrage (200A) alternant avec au moins une seconde formation d'ancrage (200B).

5. Procédé selon la revendication 4, dans lequel ladite alternance de premières formations d'ancrage (200A) et de secondes formations d'ancrage (200B) comprend des premières formations d'ancrage individuelles (200A) alternant avec des secondes formations d'ancrage individuelles (200B).

6. Procédé selon n'importe laquelle des revendications précédentes, comprenant :
la production, dans ladite alternance, de nombres égaux de premières formations d'ancrage (200A) et de secondes formations d'ancrage (200B), le substrat prémoulé laminaire (PLF, 10, 12) étant également résistant auxdites premières forces de séparation (F1) et auxdites secondes forces de séparation (F2), ou
la production, dans ladite alternance, de premières formations d'ancrage (200A) en plus grand nombre que lesdites secondes formations d'ancrage (200B), le substrat prémoulé laminaire (PLF, 10, 12) étant plus résistant auxdites premières forces de séparation (F1) qu'auxdites secondes forces de séparation (F2), ou
la production, dans ladite alternance, de secondes formations d'ancrage (200B) en plus grand nombre que lesdites premières formations d'ancrage (200A), le substrat prémoulé laminaire (PLF, 10, 12) étant plus résistant auxdites secondes forces de séparation (F2) qu'auxdites premières forces de séparation (F1).

7. Substrat (PLF), comprenant :
une structure laminaire électriquement conductrice sculptée (10) comportant des espaces en son sein, la structure laminaire incluant au moins une plage d'accueil de puce (10) présentant une première surface de plage d'accueil de puce (10A) configurée pour avoir au moins une puce de semi-conducteur (C1, C2) montée dessus ainsi qu'une seconde surface de plage d'accueil de puce (10B) opposée à la première surface de plage d'accueil de puce (10A), et
un matériau de prémoulage (12) moulé sur la structure laminaire (10), le matériau de prémoulage (12) pénétrant dans lesdits espaces et produisant un substrat prémoulé laminaire (PLF, 10, 12) incluant ladite première surface de plage d'accueil de puce (10A) laissée apparente par le matériau de prémoulage (12) avec la périphérie de l'au moins une plage d'accueil de puce (10) contiguë au matériau de prémoulage (12) moulé sur la structure laminaire (10),
**caractérisé en ce que** le long du bord périphérique de l'au moins une plage d'accueil de puce (10) est produite une alternance :
de premières formations d'ancrage (200A) de l'au moins une plage d'accueil de puce (10) au matériau de prémoulage (12), les premières formations d'ancrage (200A) étant configurées pour s'opposer à des premières forces de séparation (F1) induisant un déplacement de l'au moins une plage d'accueil de puce (10) par rapport au matériau de prémoulage (12) dans un premier sens allant de la seconde surface de plage d'accueil de puce (10B) vers la première surface de plage d'accueil de puce (10A) ; et
de secondes formations d'ancrage (200B) de l'au moins une plage d'accueil de puce (10) au matériau de prémoulage (12), les secondes formations d'ancrage (200B) étant configurées pour s'opposer à des secondes forces de séparation (F2) induisant un déplacement de l'au moins une plage d'accueil de puce (10) par rapport au matériau de prémoulage (12) dans un second sens allant de la première surface de plage d'accueil de puce (10A) vers la seconde surface de plage d'accueil de puce (10B).

8. Substrat (PLF) selon la revendication 7, dans lequel les premières formations d'ancrage (200A) et les secondes formations d'ancrage sont produites au niveau de la première surface de plage d'accueil de puce (10A) et au niveau de la seconde surface de plage d'accueil de puce (10B), respectivement.

9. Substrat (PLF) selon la revendication 7 ou la revendication 8, dans lequel les premières (200A) et les secondes (200B) formations d'ancrage (200B) comprennent des portions entaillées du bord périphérique de l'au moins une plage d'accueil de puce (10), le matériau de prémoulage (12) moulé sur la structure laminaire (10) pénétrant dans lesdites portions entaillées du bord périphérique de l'au moins une plage d'accueil de puce (10).

10. Substrat (PLF) selon n'importe laquelle des revendications 7 à 9, dans lequel ladite alternance de premières formations d'ancrage (200A) et de secondes formations d'ancrage (200B) comprend au moins une première formation d'ancrage individuelle (200A) alternant avec au moins une seconde formation d'ancrage (200B).

11. Substrat (PLF) selon n'importe laquelle la revendication 10, dans lequel ladite alternance de premières formations d'ancrage (200A) et de secondes formations d'ancrage (200B) comprend des premières formations d'ancrage individuelles (200A) alternant avec des secondes formations d'ancrage individuelles (200B).

12. Substrat (PLF) selon n'importe laquelle des revendications 7 à 11, dans lequel :
ladite alternance comprend des nombres égaux de premières formations d'ancrage (200A) et de secondes formations d'ancrage (200B), le substrat prémoulé laminaire (PLF, 10, 12) étant également résistant auxdites premières forces de séparation (F1) et auxdites secondes forces de séparation (F2), ou
ladite alternance comprend des premières formations d'ancrage (200A) en plus grand nombre que lesdites secondes formations d'ancrage (200B), le substrat prémoulé laminaire (PLF, 10, 12) étant plus résistant auxdites premières forces de séparation (F1) qu'auxdites secondes forces de séparation (F2), ou
ladite alternance comprend des secondes formations d'ancrage (200B) en plus grand nombre que lesdites premières formations d'ancrage (200A), le substrat prémoulé laminaire (PLF, 10, 12) étant plus résistant auxdites secondes forces de séparation (F1) qu'auxdites premières forces de séparation.

13. Dispositif à semi-conducteur, comprenant :
un substrat (PLF) selon n'importe laquelle des revendications 7 à 12, et
au moins une puce de semi-conducteur (C) montée sur l'au moins une surface de plage d'accueil de puce (10A) laissée apparente par le matériau de prémoulage (12).
